# EUROPEAN PATENT SPECIFICATION

(11) **EP 1 708 023 B1**
(45) Date of publication and mention of the grant of the patent: **11.03.2009**
(21) Application number: 04807469.4
(22) Date of filing: 21.12.2004
(51) Int. Cl.: G03F 7/004, G03F 7/029, G03F 7/00, G03F 7/033

(54) **NEGATIVE PHOTOSENSITIVE COMPOSITION AND NEGATIVE PHOTOSENSITIVE LITHOGRAPHIC PRINTING PLATE**
NEGATIV-LICHTEMPFINDLICHE ZUSAMMENSETZUNG UND NEGATIV-LICHTEMPFINDLICHE LITHOGRAPHISCHE DRUCKPLATTE
COMPOSITION PHOTOSENSIBLE NEGATIVE ET PLAQUE D'IMPRESSION LITHOGRAPHIQUE PHOTOSENSIBLE NEGATIVE

(30) Priority: 25.12.2003 JP 2003431478
(43) Date of publication of application: 04.10.2006
(73) Proprietor: Kodak Polychrome Graphics Japan Ltd., Tokyo 101-0062 (JP)
(72) Inventor: HAYASHI, Koji, Kodak Polychrome Graphics Japan Ltd, Oura-gun, Gunma 3700723 (JP); SAKURAI, Hideo Kodak Polychrome Graphics Japan Ltd, Oura-gun, Gunma 3700723 (JP); HAYAKAWA, Eiji Kodak Polychrome Graphics Japan Ltd, Oura-gun, Gunma 3700723 (JP)
(74) Representative: Haile, Helen Cynthia
(86) International application number: PCT/JP2004/019112
(87) International publication number: WO 2005/064402

(56) References cited:
- EP-A- 1 391 784
- EP-A- 1 518 704
- EP-A2- 0 949 539
- DE-A1- 10 250 626
- JP-A- 1 298 348
- JP-A- 5 005 988
- JP-A- 8 114 916
- JP-A- 9 067 406
- JP-A- 9 096 903
- JP-A- 11 106 413
- JP-A- 2000 109 509
- JP-A- 2000 112 322
- US-A1- 2002 051 929

## Description

### TECHNICAL FIELD

This application claims priority from Japanese Patent Application No. 2003-431478, filed on December 25, 2003, the disclosure of which is incorporated by reference herein.

The present invention relates to a negative photosensitive composition and a negative photosensitive lithographic printing plate used in the field of offset printing and, more particularly, to a negative photosensitive lithographic printing plate used as a so-called computer-to-plate (CTP) plate capable of directly forming images by irradiation with infrared light from a solid laser or a semiconductor laser based on digital signals, and a negative photosensitive composition suited for use in a photosensitive layer of the lithographic printing plate.

### BACKGROUND ART

With the progress of computer image-processing techniques, a method of directing writing images on a photosensitive layer by light irradiation corresponding to digital signals has recently been developed and thus an intense interest has been shown toward a computer-to-plate (CTP) system in which images are directly formed on a photosensitive lithographic printing plate, without outputting the images onto a silver salt mask film, by employing the method in a lithographic printing plate precursor. The CTP system, which uses high-output laser having a maximum intensity in a near infrared or infrared range as a light source for light irradiation, has the following advantages: images having high resolution can be obtained by exposure in a short time and the photosensitive lithographic printing plate used in the system can be handled in a room by daylight. Regarding solid and semiconductor lasers capable of emitting infrared light having a wavelength of 760 to 1200 nm, a high-output and portable laser is available with ease.

As the negative photosensitive lithographic printing plate which can form images using a solid laser or a semiconductor laser, a negative photosensitive lithographic printing plate comprising a photosensitive layer made of a negative photosensitive composition containing an alkali-soluble resin (for example, novolak resin), a compound which causes crosslinking reaction by an acid (for example, acid crosslinking agent such as resol resin), a compound which generates an acid by heating (acid generator) and a photothermal conversion agent (infrared absorber such as dye or pigment) is proposed in Japanese Unexamined Patent Publication (Kokai) No. 7-20629 (Patent Document 1).

In the negative photosensitive lithographic printing plate, negative images are formed by the following procedure. First, when a photosensitive layer is irradiated with infrared light from a solid laser or a semiconductor laser, infrared light is converted into heat by a photothermal conversion agent in the photosensitive layer. An acid is generated from an acid generator by the heat. Then, when preheating (heating) before developing is conducted, an acid crosslinking agent and an alkali-soluble resin cause a crosslinking reaction by a catalytic action of an acid, or acid crosslinking agents cause a crosslinking reaction, and thus the area of the photosensitive layer exposed to infrared light is made insoluble in an alkali developing solution. Consequently, an image area is formed. However, this negative photosensitive lithographic printing plate must be preheated before developing, and thus there has been required a negative photosensitive lithographic printing plate which does not require preheating.

As a negative photosensitive lithographic printing plate which can form images using a solid laser or a semiconductor laser and also require no preheating, a negative photosensitive lithographic printing plate comprising a photosensitive layer made of a negative photosensitive composition containing an infrared absorber, an onium salt, a radical polymerizable compound and a binder resin is proposed in Japanese Unexamined Patent Publication (Kokai) No. 2001-125260 (Patent Document 2).
EP-A-1 391 784, relevant under Article 54(3), describes a polymerizable.composition comprising a binder polymer containing at least one acid group having a pKa of 5.5 or more and a radical addition polymerizable group, and a radical-generating compound capable of generating a radical with light or heat, including onium sat compounds.
US Publication No 2002/0051929 and EP 0 949 539 discloses photosensitive resin compositions which may include an onium salt, especially a diazonium salt, to reduce the solubility of alkali-soluble binders.
DE 102 50 626 discloses a photosensitive composition including an aromatic water-soluble polymer including a cationic onium group in a side chain. EP 1 518 704, relevant under Article 54(3), describes a photosensitive composition comprising a polymerizable compound, an infrared absorber and an onium salt.
JP-A-9 067 406 and JP 2000 109509 describe photopolymerization compositions comprising a compound having a radically polymerizable ethylenically unsaturated bond, an aromatic onium salt, an ammonium borate compound and a sensitizer.
None of the above patent specifications disclose the use of an onium salt comprising at least two onium ion atoms in a molecule for use in a negative photosensitive composition.

In this negative photosensitive lithographic printing plate, the onium salt functions as an initiator of radical polymerization. Therefore, when irradiated with infrared light, the radical polymerization of the radical polymerizable compound proceeds and the photosensitive layer is cured, and thus the photosensitive layer exposed to infrared light is made insoluble in a developing solution. Consequently, an image area is formed. However, in this negative photosensitive lithographic printing plate, polymerization inhibition is caused by oxygen in the air during the radical polymerization. Therefore, the negative photosensitive lithographic printing plate is inferior in printing durability because of low sensitivity and insufficient strength of the image area thus formed. This negative photosensitive lithographic printing plate also had a problem that sensitivity deteriorates with the lapse of time after production and also storage stability is poor.
Patent Document 1: Japanese Unexamined Patent Publication (Kokai) No. 7-20629
Patent Document 2: Japanese Unexamined Patent Publication (Kokai) No. 2001-125260

### DISCLOSURE OF THE INVENTION

### Problems to be Solved by the Invention

An object of the present invention is to provide a negative photosensitive composition which is curable by infrared light and is less likely to cause polymerization inhibition due to oxygen during radical polymerization, and is also excellent in storage stability, and to provide a negative photosensitive lithographic printing plate which can directly form images by irradiation with infrared light from a solid laser or a semiconductor laser based on digital signals without preheating and shows high sensitivity, and is also excellent in printing durability and storage stability.

### Means for Solving the Problems

That is, the negative photosensitive composition of the present invention comprises: (A) an infrared absorber,
(B) an organic boron compound which exerts a functions a polymerization initiator by using in combination with the infrared absorber (A), (C) an onium salt having at least two onium ion atoms in a molecule, and (D) a compound having a polymerizable unsaturated group.

The infrared absorber (A) is preferably a near infrared absorbing cationic dye represented by the following formula (1):

D⁺A⁻ (1)

wherein
D⁺ represents a cationic dye having an absorption in a near infrared range, and
A⁻ represents an anion.

The organic boron compound (B) is preferably an ammonium salt of a quaternary boron anion represented by the following formula (2): 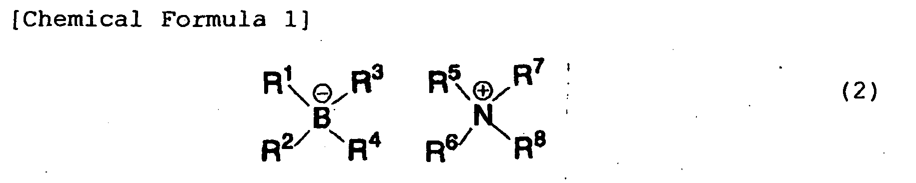 wherein
R¹, R², R³ and R⁴ each independently represents an alkyl group, an aryl group, an alkaryl group, an allyl group, an aralkyl group, an alkenyl group, an alkynyl group, an alicyclic group, or a saturated of unsaturated heterocyclic group,
at least one of R¹, R², R³ and R⁴ is an alkyl group having 1 to 8 carbon atoms, and
R⁵, R⁶, R⁷ and R⁸ each independently represents a hydrogen atom, an alkyl group, an aryl group, an allyl group, an alkaryl group, an aralkyl group, an alkenyl group, an alkynyl group, an alicyclic group, or a saturated or unsaturated heterocyclic group.

The onium salt (C) has at least two onium ion atoms in a molecule. The onium ion atoms are preferably S⁺ and I⁺.

The onium salt (C) preferably has an aromatic ring having a substituent.

The negative photosensitive composition of the present invention further contains a binder resin (E), preferably. The binder resin (E) preferably comprises an alkali-soluble resin or a polymer having an aromatic carboxyl group.

The negative photosensitive lithographic printing plate of the present invention comprises a support, and a photosensitive layer containing the negative photosensitive composition of the present invention formed on the support.

### Effect of the Invention

The negative photosensitive composition of the present invention comprises: (A) an infrared absorber, (B) an organic boron compound which exerts a function as a polymerization initiator by using in combination with the infrared absorber (A), (C) an onium salt having at least two onium ion atoms in a molecule, and (D) a compound having a polymerizable unsaturated group and is therefore curable by infrared light and is less likely to cause polymerization inhibition due to oxygen during radical polymerization, and also excellent in storage stability.

The negative photosensitive lithographic printing plate of the present invention comprises a support, and a photosensitive layer containing the negative photosensitive composition of the present invention formed on the support and therefore can directly form images by irradiation with infrared light from a solid laser or a semiconductor laser based on digital signals without preheating and shows high sensitivity, and is also excellent in printing durability and storage stability.

### BEST MODE FOR CARRYING OUT THE INVENTION

The present invention will now be described in detail.

### <(A) Infrared absorber>

The infrared absorber (A) in the present invention is a material having a maximum absorption wavelength in a near infrared or the infrared range, for example, a maximum absorption wavelength in a range from 760 nm to 1200 nm. Examples of the material include various pigments or dyes.

The pigments used in the present invention are commercially available dyes described, for example, in "Color Index Handbook, "Latest Pigment Handbook" (edited by Nihon Pigment Technique Society, published in 1977), "Latest Pigment Application Technique" (published by CMC in 1986), and "Printing Ink Technique" (published by CMC in 1984). Applicable types of pigment include black, yellow, orange, brown, red, violet, blue and green pigments, fluorescent pigments and polymer-grafted dyes. For example, there can be used insoluble azo pigments, azo lake pigments, condensed azo pigments, chelated azo pigments, phthalocyanine pigments, anthraquinone pigments, perylene and perinone pigments, thiomindigo pigments, guinacridone pigments, dioxazine pigments, isoindolinone pigments, quinophthalone pigments, lake pigments, azine pigments, nitroso pigments, nitro pigments, natural pigments, fluorescent pigments, inorganic pigments and carbon black.

Among these pigments, carbon black is preferably used as a material which efficiently absorbs light in a near infrared or infrared range and is also economically excellent. As the carbon black, grafted carbon blacks having various functional groups, which are excellent in dispersibility, are commercially available and examples thereof include those described on page 167 of "The Carbon Black, Handbook, 3rd edition" (edited by the Carbon Black Society of Japan and issued in 1995" and those described in page 111 of "Characteristics, Optimum Blending and Applied Technique of Carbon Black" (edited by Technical Information Society in 1997), all of which are preferably used in the present invention.

These pigments may be used without surface treatment, or may be used by well-known surface treatment. As a method of surface treatment, there can be contemplated a method of surface-coating a resin or a wax, a method of attaching a surfactant, and a method of binding a reactive substance (e.g. silane coupling agent, epoxy compound, polyisocyanate etc.) to the surface of a pigment. The above-mentioned surface treating methods are described in "Property and Application of Metal Soap" (Saiwai Shobou), "Printing Ink Technique" (published by CMC in 1984) and "Latest Pigment Application Technique" (published by CMC in 1986). The particle size of these pigments is preferably in a range from 0.01 to 15 µm, and more preferably from 0.01 to 5 µm.

The dyes used in the present invention are conventionally known commercially available dyes described, for example, in "Dye Handbook" (edited by the Association of Organic Synthesis Chemistry, published in 1970), "Handbook of Color Material Engineering" (edited by the Japan Society of Color Material, Asakura Shoten K. K., published in 1989), "Technologies and Markets of Industrial Pigments" (published by CMC in 1983), and "Chemical Handbook, Applied Chemistry Edition" (edited by The Chemical Society of Japan, Maruzen Shoten K. K., published in 1986). Specific examples of the dyes include azo dyes, azo dyes in the form of metal complex salts, pyrazolone azo dyes, anthraquinone dyes, phthalocyanine dyes, carbonium dyes, quinonimine dyes, methine dyes, cyanine dyes, indigo dyes, quinoline dyes, nitro-based dyes, xanthene-based dyes, thiazine-based dyes, azine dyes, and oxazine dyes.

Examples of the dye capable of efficiently absorbing near infrared light or infrared light include cyanine dyes, methine dyes, naphthoquinone dyes, squalirium pigments, arylbenzo(thio)pyridinium salts, trimethinethiapyrylium salts, pyrylium-based compounds, pentamethinethiopyrylium salts and infrared absorbing dyes.

Among these dyes, a near infrared absorbing cationic dye represented by the following general formula (1):

D⁺A⁻ (1)

wherein D⁺ represents a cationic dye having an absorption in a near infrared range and A⁻ represents an anion, is preferable as the infrared absorber (A) because it enables the below described organic boron compound (B) to efficiently exert a polymerization function.

Examples of the cationic dye having an absorption in a near infrared range include cyanine-based dyes, triarylmethane-based dyes, ammonium-based dyes and diimmonium-based dyes, each having an absorption in a near infrared range. Specific examples of the cationic dye having an absorption in a near infrared range include the following.

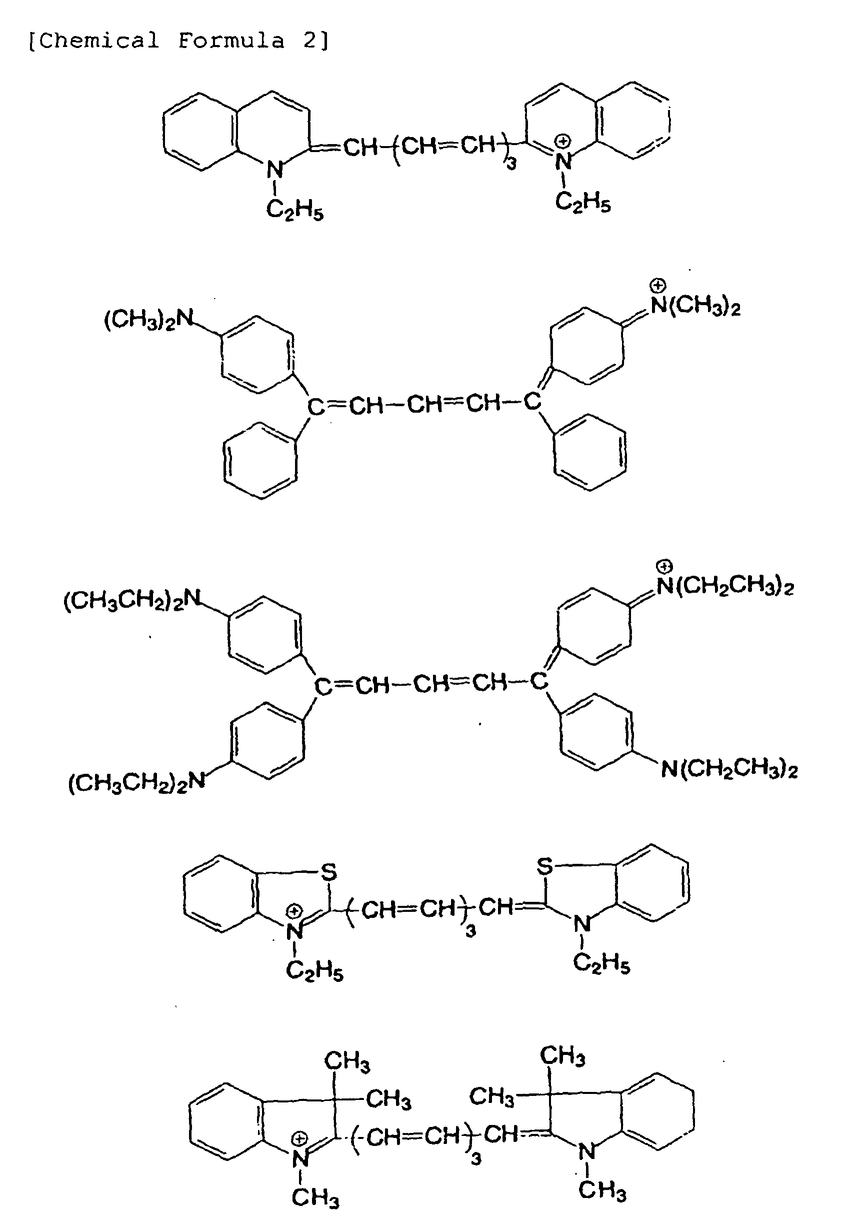

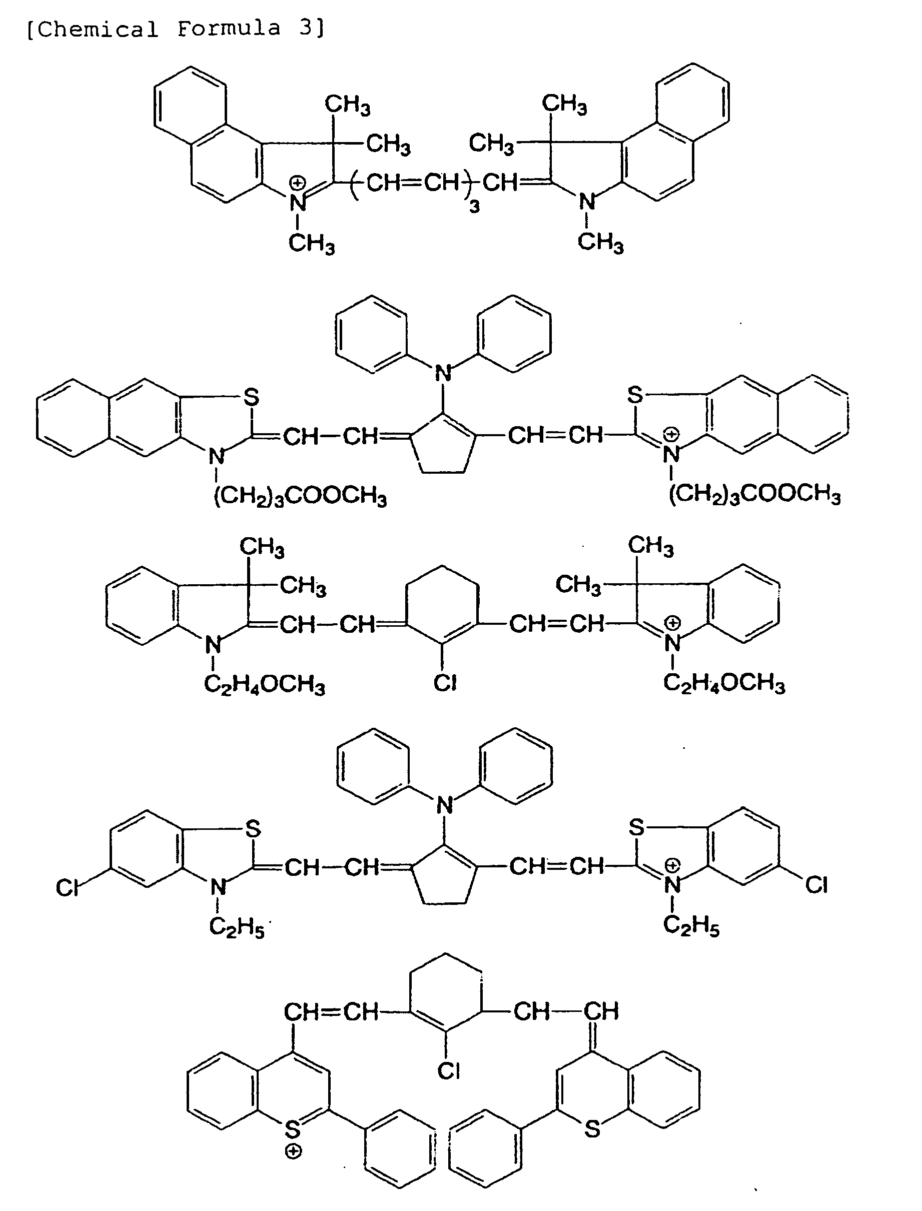

Examples of the anion include halogen anion, ClO₄⁻, PF₆⁻, BF₄⁻, SbF₆⁻, CH₃SO₃⁻, CF₃SO₃⁻, C₆H₅SO₃⁻, CH₃C₆H₄SO₃⁻, HOC₆H₄SO₃⁻, ClC₆H₄SO₃⁻, and boron anion represented by the following formula (3): 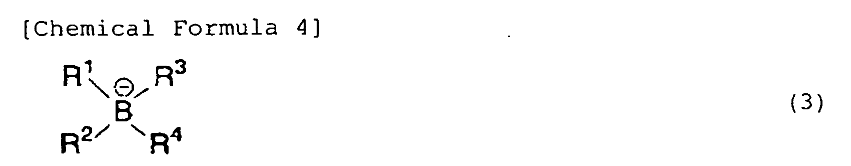 wherein
R¹, R², R³ and R⁴ each independently represents an alkyl group, an aryl group, an alkaryl group, an allyl group, an aralkyl group, an alkenyl group, an alkynyl group, an alicyclic group, or a saturated or unsaturated heterocyclic group, and
at least one of R¹, R², R³ and R⁴ is an alkyl group having 1 to 8 carbon atoms. The boron anion is preferably a triphenyl n-butylboron anion or a trinaphthyl n-butylboron anion.

Among cationic dyes having an absorption in a near infrared range, preferred is a dye represented by the following formula (4): 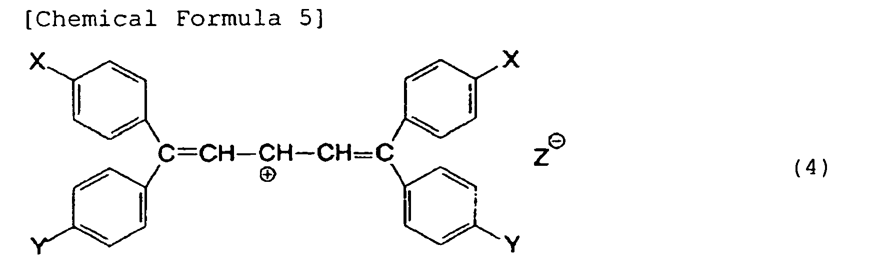 wherein
X represents N(C₂H₅)₂ or N(CH₃)₂,
Y represents N(C₂H₅)₂, H, or OCH₃, and
Z⁻ is an anion represented by the following formula. 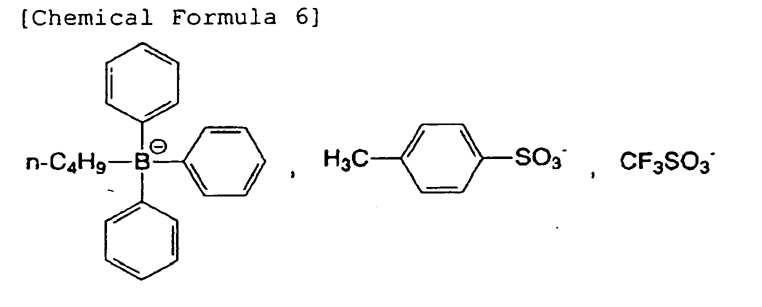
As these pigments have a maximum absorption wavelength within a range from 817 to 822 nm, the resulting photosensitive lithographic printing plate is suited for an exposure apparatus equipped with an existing near infrared semiconductor laser. As the molar absorption coefficient is 1 × 10⁵ or more, the resulting photosensitive lithographic printing plate is excellent in sensitivity.

The infrared absorber (A) is used in the following manner. That is, at least one proper pigment or dye capable of absorbing a specific wavelength of a light source described hereinafter is selected from the above pigments or dyes and then added to the negative photosensitive composition.

When a pigment is used as the infrared absorber (A), the content of the pigment is preferably within a range from 0.5 to 15% by weight, and particularly preferably from 1 to 10% by weight, based on the entire solid content of the negative photosensitive composition. When the content of the pigment is less than 0.5% by weight, infrared light is not sufficiently absorbed. On the other hand, when the content of the pigment is more than 15% by weight, an excess quantity of heat tends to be generated, and it is not preferred.

When a dye is used as the infrared absorber (A), the content of the dye is preferably within a range from 0.5 to 15% by weight, and particularly preferably from 1 to 10% by weight, based on the entire solid content of the negative photosensitive composition. When the content of the dye is less than 0.5% by weight, infrared light is not sufficiently absorbed. On the other hand, when the content of the dye is more than 15% by weight, absorption of infrared lights is substantially saturated and the effect of the addition of the dye may not increase, and therefore it is not preferred.

### <(B) Organic boron compound>

The organic boron compound (B) in the present invention exerts a function as a polymerization,initiator by using in combination with the above infrared absorber (A). The organic boron compound (B) is preferably an ammonium salt of a quaternary boron anion represented by the following formula (2): 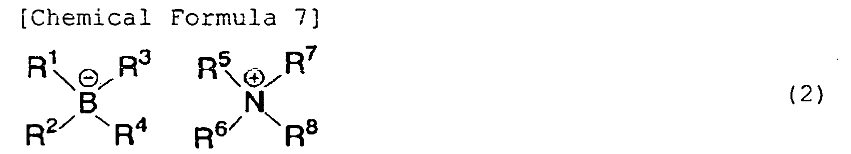 wherein
R¹, R², R³ and R⁴ each independently represents an alkyl group, an aryl group, an alkaryl group, an allyl group, an aralkyl group, an alkenyl group, an alkynyl group, an alicyclic group, or saturated or unsaturated heterocyclic group,
at least one of R¹, R², R³ and R⁴ is an alkyl group having 1 to 8 carbon atoms, and
R⁵, R⁶, R⁷ and R⁸ each independently represents a hydrogen atom, an alkyl group, an aryl group, an allyl group, an alkaryl group, an aralkyl group, an alkenyl group, an alkynyl group, an alicyclic group, or a saturated or unsaturated heterocyclic group.

Among these, tetra n-butylammonium triphenyl borate, tetra n-butylammonium trinaphthyl borate, tetra n-butylammonium tri(p-t-butylphenyl) borate, tetramethylammonium n-butyltriphenyl borate, tetramethylammonium n-butyltrinaphthyl borate, tetramethylammoniumn-octyltriphenyl borate, tetramethylammonium n-octyltrinaphthyl borate, tetraethylammonium n-butyltriphenyl borate, tetraethylammonium n-butyltrinaphthyl borate, trimethylhydrogenammonium n-butyltriphenyl borate, triethylhydrogenammonium n-butyltriphenyl borate, tetrahydrogenammonium n-butyltriphenyl borate, tetramethylammonium tetran-butyl borate and tetraethylammonium tetran-butyl borate can be preferably used because a polymerization function can be efficiently exerted.

The organic boron compound (B) in the present invention can exert a function as a polymerization initiator by using in combination with the above infrared absorber (A) (for example, D⁺A⁻) in case of generating a radical (R·) by irradiation with infrared light, as shown in the following scheme (5):

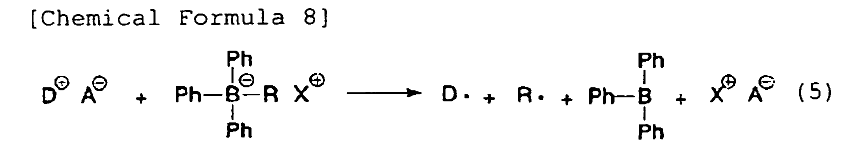

wherein Ph represents a phenyl group, R represents can alkyl group having 1 to 8 carbon atoms, and X⁺ represents an ammonium ion.

The content of the organic boron compound (B) is preferably within a range from 1 to 15% by weight, and particularly preferably from 3 to 10% by weight, based on the solid content of the negative photosensitive composition. When the content of the organic boron compound (B) is less than 1% by weight, insufficient polymerization reaction leads to poor curing and the resulting negative photosensitive lithographic printing plate has a weak image area. On the other hand, when the content of the organic boron compound (B) is more than 15% by weight, the polymerization reaction does not efficiently arise. If necessary, at least two organic boron compounds (B) may be used in combination. Also the organic boron compound (B) may be used in combination with known polymerization initiators used in the radical polymerization, such as triazines.

### <(C) Onium salt>

The onium salt (C) in the present invention is a salt comprising a cation having at least two onium ion atoms in the molecule, and an anion.

Examples of the onium ion atom in the onium salt (C) include S⁺ atom in sulfonium, I⁺ atom in iodonium, N⁺ in ammonium, and P⁺ atom in phosphonium (excluding diazonium compound such as diazo resin). Among these onium ion atoms, S⁺ and I⁺ atoms are preferable.

Examples of the anion of the onium salt (C) include halogen anion, C10₄⁻₁ PF₆⁻, BF₄⁻, SbF₆⁻, CH₃SO₃⁻, CF₃SO₃⁻, C₆H₅SO₃⁻, CH₃C₆H₄SO₃⁻, HOC₆H₄SO₃⁻, ClC₆H₄SO₃⁻, and boron anion represented by the formula (3).

The onium salt (C) is preferably obtained by combining an onium salt having S⁺ in the molecule with an onium salt having I⁺ in the molecule in view of sensitivity and storage stability.

In view of sensitivity and storage stability, the onium salt (C) is a polyvalent onium salt having at least two onium ion atoms in the cation bonded through a covalent bond. Among polyvalent onium salts, those having S⁺ and I⁺ in the molecule are particularly preferable. Particularly preferable polyvalent onium salts are represented by the following formula (6): 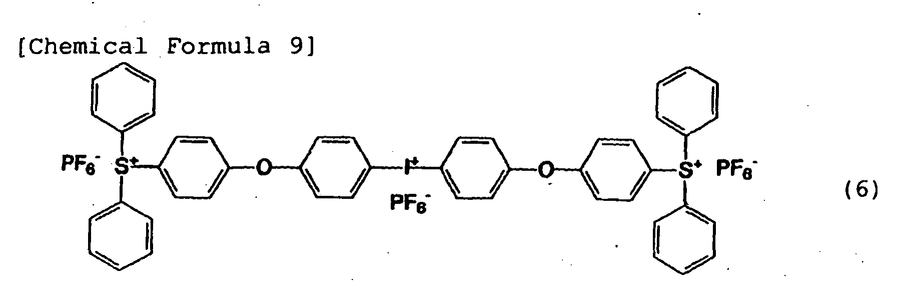 and the formula (7):

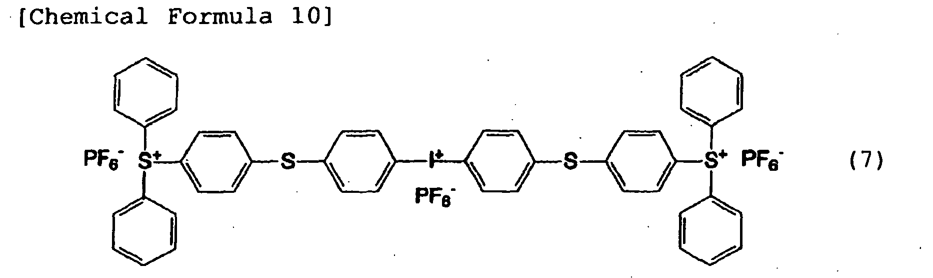

In view of sensitivity, developing properties and printing durability, the onium salt (C) preferably contains an aromatic ring having a substituent. The substituent is preferably a C₁-C₆ alkyl group such as methyl group, ethyl group, propyl group, isopropyl group, butyl group, isobutyl group, sec-butyl group, tert-butyl group, pentyl group, isopentyl group, neopentyl group, tert-pentyl group, hexyl group or isohexyl group, and is particularly preferably a methyl group, a sec-butyl group, a tert-butyl group or a tert-pentyl group. Examples of the aromatic ring include benzene ring and naphthalene ring, and a benzene ring is preferable.

It is particularly preferred that the onium salt (C) contains at least two aromatic rings having a substituent. In that case, the substituent may be the same or different.

The content of the onium salt (C) is preferably within a range from 2 to 30% by weight, and particularly preferably from 5 to 20% by weight, based on the solid content of the negative photosensitive composition. When the content of the onium salt (C) is less than 2% by weight, the resulting negative photosensitive lithographic printing plate may be insufficient in sensitivity and printing durability because of insufficient polymerization reaction. On the other hand, when the content of the onium salt (C) is more than 30% by weight, the resulting negative photosensitive lithographic printing plate is inferior in developing properties. If necessary, at least two onium salts (C) may be used in combination. Also the polyhydric onium salt may be used in combination with the onium salt.

### <(D) Compound having polymerizable unsaturated group>

The compound having a polymerizable unsaturated group (D) in the present invention is a monomer or oligomer which has at least one, preferably at least two addition-polymerizable ethylenically unsaturated groups, and preferably has a boiling point of 100°C or higher at normal pressure.

Examples of the monomer or oligomer monofunctional (meth)acrylates such as polyethylene glycol mono(meth)acrylate [hereinafter, methacrylate and acrylate are generically referred to as (meth)acrylate], polypropylene glycol mono(meth)acrylate, phenoxyethyl(meth)acrylate; polyfunctional (meth)acrylates such as polyethylene glycol di(meth)acrylate, polypropylene glycol di(meth)acrylate, trimethylolpropane tri(meth)acrylate, neopentyl glycol di(meth)acrylate, pentaerythritol tri(meth)acrylate, pentaerythritol tetra(meth)acrylate, dipentaerythritol hexa(meth)acrylate, hexanediol di(meth)acrylate, tri(acryloyloxyethyl) isocyanurate, (meth)acrylate of polyhydric alcohol-alxylene oxide adduct, (meth)acrylate of polyhydric phenol-alkylene oxide adduct, urethane acrylates, polyester acrylates, and epoxy acrylates obtained by addition reaction of an epoxy resin and (meth)acrylic acid; and polyfunctional allyl compounds such as allyl isocyanurate and allyl cyanurate.

The content of the compound having a polymerizable unsaturated group (D) is preferably within a range from 5 to 60% by weight based on the solid content of the negative photosensitive composition. When the content of the compound having a polymerizable unsaturated group (D) is less than 5% by weight, insufficient curing occurs.
On the other hand, when the content of the compound having a polymerizable unsaturated group (D) is more than 60% by weight, the photosensitive layer of the resulting negative photosensitive lithographic printing plate is sticky. If necessary, at least two compounds having a polymerizable unsaturated group (D) may be used in combination.

### <(E) Binder resin>

As the binder resin (E) in the present invention, there can be used binder resins which have conventionally been used in a negative photosensitive lithographic printing plate. Examples of the binder resin include a copolymer such as meth)acrylic acid-(meth)acrylate ester copolymer, hydroxyalkyl(meth)acrylate- and (meth)acrylonitrile-containing copolymer, copolymer having an aromatic hydroxyl group, or a polymer having a 2-hydroxy-3-phenoxypropyl (meth)acrylate unit; epoxy resin; polyamide resin; vinyl halide such as polyvinyl chloride or polyinylidene chloride; vinyl polyacetate; polyester; acetal resin such as formal resin or butyral resin; soluble polyurethane resin which is commercially available from Goodrich Corporation, USA under the trade name of Estan; polystyrene; styrene-maleic anhydride copolymer or half ester thereof; a cellulose derivative; shellac; a rosin or modified compound thereof; and a copolymer having an unsaturated group in the side chain.

The binder resin (E) is preferably an alkali-soluble resin because it is possible to develop it with a developing solution of an aqueous alkali solution. The alkali-soluble resin refers to a binder resin which is insoluble in water and is soluble in an aqueous alkali solution, and is specifically a resin having an alkali-soluble group such as carboxyl group, phenolic hydroxyl group, sulfonic acid group, phosphone group, active imino group or N-sulfonylamide group.

Examples of the alkali-soluble resin include novolak resin or resol resin, such as phenol-formaldehyde resin, cresol-formaldehyde resin or phenol-cresol-formaldehyde cocondensed resin; polyhydroxystyrene such as polyhydroxystyrene or polyhalogenated hydroxystyrene; acrylic resin having at least one unit derived from a monomer having an acidic group, such as N-(4-hydroxyphenyl)methacrylamide, hydroquinone monomethacrylate, N-(sulfamoylphenyl)methacrylamide, N-phenylsulfonylmethacrylamide, N-phenylsulfonylmaleimide, acrylic acid, methacrylic acid, N-(4-carboxyphenyl)methacrylamide, 4-carboxystyrene or mono(2-methacryloxyethyl) hexahydrophthalate; vinyl-based resin having an active methylene group or a urea bond; polyurethane resin such as polyurethane resin having an N-sulfonylamide group, an N-sulfonylureide group or an N-aminosulfonylamide group, polyurethane resin having an active imino group, or polyurethane resin having a carboxyl group; polyamide resins such as polyhydroxypolyamide; and polyester resin having a phenolic hydroxyl group.

As the binder resin (E), a binder resin having a polymerizable unsaturated group such as an acryloyl group, a methacryloyl group or an allyl group in the side chain is preferably used. Since such a binder resin and a compound having a polymerizable unsaturated group (C) cause the crosslinking reaction, thereby to increase the crosslink density, the printing durability of the photosensitive lithographic printing plate is more improved.

The binder resin (E) is preferably a polymer having an aromatic carboxyl group, and particularly preferably a copolymer, in view of printing durability. The aromatic carboxyl group is an aromatic group having a carboxyl moiety and includes, for example, -C₆H₅COOH. The aromatic carboxyl group exists in the side chain of a (co)polymer, or may be directly linked to the main chain of the (co)polymer or linked via a spacer. The spacer includes, for example, a divalent group such as alkylene group, - CO-, -COO-, -CONH-, -NH- or -NHCONH-.

The content of the binder resin (E) is preferably within a range from 20 to 70% by weight based on the solid content of the negative photosensitive composition. When the content of the binder resin (E) is less than 20% by weight, the resulting negative photosensitive lithographic printing plate has a weak image area because of poor curing. On the other hand, when the content of the binder resin (E) is more than 70% by weight, efficiency of the curing reaction is inferior. If necessary, at least two binder resins (E) may be used in combination.

### <Negative photosensitive composition>

To the negative photosensitive composition of the present invention, known additives such as colorants (dyes, pigment), surfactants, plasticizers, stability modifiers and polymerization inhibitors can be added, if necessary.

Examples of preferable dyes include basic oil-soluble dyes such as Crystal Violet, Malachite Green, Victoria Blue, Methylene Blue, Ethyl Violet and Rhodamine B. Examples of the commercially available dyes include "Victoria Pure Blue BOH" [manufactured by HODOGAYA CHEMICAL Co., Ltd.], "Oil Blue #603" [manufactured by Orient Chemical Industries, LTD.], "VPB-Naps (naphthalene sulfonate of Victoria Pure Blue)" [manufactured by HODOGAYA CHEMICAL Co., Ltd.] and "D11" [manufactured by PCAS Co.]. Examples of the pigments include Phthalocyanine Blue, Phthalocyanine Green, Dioxadine Violet and Quinacridone Red.

Examples of the surfactants include fluorine-based surfactants and silicone-based surfactants.

Examples of the plasticizer include diethyl phthalate, dibutyl phthalate, dioctyl phthalate, tributyl phosphate, trioctyl phosphate, tricresyl phosphate, tri(2-chloroethyl) phosphate and tributyl citrate.

As the known stability modifier, for example, phosphoric acid, phosphorous acid, oxalic acid, tartaric acid, malic acid, citric acid, dipicolinic acid, polyacrylic acid, benzenesulfonic acid and toluenesulfonic acid can be used in combination.

Examples of the polymerization inhibitors include known phenolic compound, quinones, N-oxide compound, amine-based compound, sulfide group-containing compound, nitro group-containing compound and transition metal compound. Specific examples thereof include hydroquinone, p-methoxyphenol, p-cresol, pyrogallol, t-butylcatechol, benzoquinone, 4,4'-thiobis(3-methyl-6-t-butylphenol), 2,2'-methylenebis(4-methyl-6-t-butylphenol), 2-mercaptobenzimidazole and N-nitrosophenylhydroxyamine primary cerium salt.

The contents of these various additives vary depending on the purposes, but are preferably within a range from 0 to 30% by weight based on the solid content of the photosensitive composition.

The negative photosensitive composition of the present invention may contain higher fatty acids such as stearic acid, behenic acid amide or methyl behenate. When the negative photosensitive composition of the present invention is applied on the support and dried to form a photosensitive layer, higher fatty acids ooze out on the surface of the photosensitive layer thereby to coat the surface of the photosensitive layer, and thus penetration of oxygen in the air, which inhibits the polymerization reaction in the photosensitive layer and penetration of a low-molecular compound such as basic substance into the photosensitive layer, is prevented.

For the purpose of improving the printing durability of the resulting negative photosensitive lithographic printing plate, the negative photosensitive composition of the present invention may contain sensitizers such as hexaarylbiimidazoles and ketocoumarines; a cyanine-based sensitizing dye cation having a structure in which a heterocycle is linked via a polymethine chain and/or a phthalocyanine-based sensitizing dye.

In the above-described negative photosensitive composition, as the infrared absorber (A) is used in combination with the organic boron compound (B) which has a function as a polymerization initiator by using in combination with the infrared absorber (A), the polymerization of the compound having a polymerizable unsaturated group (D) proceeds under infrared light. Therefore, this negative photosensitive composition is curable with infrared light.

Although the reason is not clear, by using the organic boron compound (B) as the polymerization initiator, polymerization inhibition due to oxygen is less likely to occur during the radical polymerization.

Although the reason is not clear, the use of the onium salt (C) accelerates the radical polymerization initiated by using the infrared absorber (A) in combination with the organic boron compound (B). Also, the storage stability of the negative photosensitive composition is improved. These effects are not exerted if the organic boron compound (B) and the onium salt (C) are not used in combination, and are not exerted if the boron compound (B) is not used and the onium salt (C) is used alone as the polymerization initiator.

As described above, by using the negative photosensitive composition containing the organic boron compound (B), which causes less polymerization inhibition due to oxygen during the radical polymerization, and the onium salt (C), which accelerates the radical polymerization thereby to improve storage stability, as the photosensitive layer of the negative photosensitive lithographic printing plate, it becomes possible to obtain a negative photosensitive lithographic printing plate which shows high sensitivity and is excellent in printing durability and storage stability.

### <Negative photosensitive lithographic printing plate>

The negative photosensitive lithographic printing plate of the present invention is schematically composed of a support and a photosensitive layer, made of the negative photosensitive composition, formed on the support.

Examples of the support used include metal plates such as aluminum, zinc, copper, stainless steel, and iron plates; plastic films such as polyethylene terephthalate, polycarbonate, polyvinyl acetal, and polyethylene films; composite materials obtained by vacuum-depositing or laminating a metal layer on papers or plastic films on which a synthetic resin is melt-coated or a synthetic resin solution is coated; and materials used as the support of the printing plate. Among these supports, aluminum and composite supports coated with aluminum are preferably used.

The surface of the aluminum support is preferably subjected to a surface treatment for the purpose of enhancing water retention and improving adhesion with the photosensitive layer. Examples of the surface treatment include surface roughening treatments such as brush polishing, ball polishing, electrolytic etching, chemical polishing, liquid honing, sand blasting, and a combination thereof. Among these surface treatments, a surface roughening treatment including the use of electrolytic etching is preferable. As the electrolytic bath used in the electrolytic etching, an aqueous solution containing an acid, an alkali or a salt thereof, or an aqueous solution containing an organic solvent is used. Among these, an electrolytic solution containing hydrochloric acid, nitric acid, or a salt thereof is preferable.

The aluminum plate subjected to the surface roughening treatment is subjected to desmutting using an aqueous solution of an acid or alkali, if necessary. The aluminum support thus obtained is preferably subjected to an anodizing treatment. An anodizing treatment of treating using a bath containing sulfuric acid or phosphoric acid is particularly preferable.

If necessary, it is possible to conduct silicate treatment (sodium silicate, potassium silicate), potassium fluorozirconate treatment, phosphomolybdate treatment, alkyl titanate treatment, polyacrylic acid treatment, polyvinylsulfonic acid treatment, polyvinylphosphonic acid treatment, phytic acid treatment, treatment with a salt of hydrophilic organic polymer compound and divalent metal, hydrophilization treatment by undercoating with a water soluble polymer having an sulfonic acid group, coloring treatment with an acidic dye, and electrodeposition with silicate.

The aluminum support is preferably subjected to a sealing treatment after subjecting to the surface roughening treatment (graining treatment) and the anodizing treatment. The sealing treatment can be conducted by dipping an aluminum support in hot water or a hot water solution containing an inorganic or organic salt, or using a steam bath.

The negative photosensitive lithographic printing plate of the present invention is produced by applying a solution or dispersion, which is prepared by dissolving or dispersing a negative photosensitive composition in an organic solvent, on the surface of a support, followed by drying to form a photosensitive layer on the support.

As an organic solvent in which the negative photosensitive composition is dissolved or dispersed, for example, any conventionally known organic solvent can be used. Among these organic solvents, those having a boiling point within a range from 40 to 200°C, particularly from 60 to 160°C, are selected because it is advantageous in case of drying.

Examples of the organic solvent include alcohols such as methyl alcohol, ethyl alcohol, n- or iso-propyl alcohol, n- or iso-butyl alcohol and diacetone alcohol; ketones such as acetone, methyl ethyl ketone, methyl propyl ketone, methyl butyl ketone, methyl amyl ketone, methyl hexyl ketone, diethyl ketone, diisobutyl ketone, cyclohexanone, methylcyclohexanone and acetylacetone; hydrocarbons such as hexane, cyclohexane, heptane, octane, nonane, decane, benzene, toluene, xylene and methoxybenzene; acetate esters such as ethyl acetate, n- or iso-propyl acetate, n- or iso-butyl acetate, ethylbutyl acetate and hexyl acetate; halides such as methylene dichloride, ethylene dichloride and monochloorbenzene; ethers such as isopropyl ether, n-butyl ether, dioxane, dimethyldioxane and tetrahydrofuran; polyhydric alcohols and derivatives thereof, such as ethylene glycol, ethylene glycol monomethyl ether, ethylene glycol monomethyl ether acetate, ethylene glycol monoethyl ether, ethylene glycol monoethyl ether acetate, ethylene glycol monobutyl ether, ethylene glycol monobutyl ether acetate, ethylene glycol dimethyl ether, ethylene glycol diethyl ether, ethylene glycol dibutyl ether, methoxyethoxy ethanol, diethylene glycol monomethyl ether, diethylene glycol dimethyl ether, diethylene glycol methylethyl ether, diethylene glycol diethyl ether, propylene glycol, propylene glycol monomethyl ether, propylene glycol monomethyl ether acetate, propylene glycol monoethyl ether, propylene glycol monoethyl ether acetate, propylene glycol monobutyl ether, 3-methyl-3-methoxybutanol and 1-methoxy-2-propanol; and special solvents such as dimethyl sulfoxide, N,N-dimethylformamide, methyl lactate and ethyl lactate. These organic solvents are used alone or in combination. The solid content in the negative photosensitive composition to be applied is preferably adjusted within a range from 2 to 50% by weight. The solid content as used herein means a component other than the organic solvent.

As the method of coating a negative photosensitive composition, for example, there can be used roll coating, dip coating, air knife coating, gravure coating, guravure offset coating, hopper coating, blade coating, wire doctor coating, and spray coating methods. The coating weight of the negative photosensitive composition is preferably within a range from 10 to 100 ml/m².

The negative photosensitive composition applied on the support is usually dried in heated air. The drying temperature (temperature of the heated air) is preferably within a range from 30 to 200°C, and particularly preferably from 40 to 140°C. Not only a method of maintaining the drying temperature at a fixed temperature, but also a method of stepwisely raising the drying temperature can be employed. Preferred results can sometimes be obtained by dehumidifying the air. The heated air is preferably blown against the surface to be coated at a rate within a range from 0.1 to 30 m/second, and particularly preferably from 0.5 to 20 m/second.

The coating weight of the negative photosensitive composition is usually within a range from about 0.5 to 5 g/m², in terms of a dry weight.

In the negative photosensitive lithographic printing plate of the present invention, a protective layer can be formed on the photosensitive layer so as to conduct laser irradiation in air. The protective layer prevents penetration of oxygen in the air, which inhibits the polymerization reaction in the photosensitive layer, and penetration of a low-molecular compound such as basic substance into the photosensitive layer, and enables laser irradiation in air. Therefore, the characteristics required of the protective layer include low permeability to a low-molecular compound such as oxygen, and good permeability to light used for exposure, excellent adhesion with the photosensitive layer and easy removal during developing treatment after laser irradiation.

As the material of the protective layer, for example, a water-soluble polymer compound having comparatively excellent crystallinity can be used, and specific examples thereof include a water-soluble polymer such as polyvinyl alcohol, polyvinyl pyrrolidone, an acidic cellulose, gelatin, gum arabic or polyacrylic acid. The use of polyvinyl alcohol among these polymers as a main component give good results to the basic characteristics such as oxygen screening properties and development eliminating property. Polyvinyl alcohol used in the protective layer may be partially substituted with an ester, an ether and an acetal as far as it contains an unsubstituted vinyl alcohol unit for imparting the required oxygen screening properties and water solubility. Similarly, a portion of polyvinyl alcohol contains the other copolymer component.

Specific examples of polyvinyl alcohol (PVA) include those having a hydrolysis rate of 71 to 100% and a molecular weight within a range from 300 to 2400. Specific examples thereof include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613 and L-8, which are manufactured by Kuraray Co., Ltd.

Components of the protective layer (selection of PVA, use of additives) and the coating weight are selected taking account of fog resistance, adhesion and scratch resistance, in addition to oxygen screening properties and development eliminating property. The higher the hydrolysis rate of PVA to be used (the higher the content of an unsubstituted vinyl alcohol unit in the protective layer), the larger the thickness, the more oxygen screening properties are enhanced, and thus it is advantageous in view of sensitivity. However, when oxygen screening properties are extremely enhanced, there arise problems that undesired polymerization reaction occurs during the production and storage and undesired fog and line pattern thickening occur during laser irradiation. Also adhesion with the image area and scratch resistance are very important in view of handling of the plate. That is, when a hydrophilic layer made of a water-soluble polymer is laminated on a hydrophilic polymer layer, film peeling due to a poor adhesive force is likely to occur and the peeled portion causes defects such as poor film curing due to polymerization inhibition of oxygen. The method of improving adhesion between two layers includes a method of mixing a hydrophilic polymer, composed mainly of polyvinyl alcohol, with 20 to 60% by weight of am acrylic emulsion or a water-soluble vinyl pyrrolidone-vinyl acetate copolymer.

The negative photosensitive lithographic printing plate of the present invention can be used as a so-called computer-to-plate (CTP) plate which can directly write images on a plate using laser based on digital image information from a computer.

As a light source laser in the present invention, a high-output laser having a maximum intensity within a near infrared or infrared range is most preferably used because a negative photosensitive lithographic printing plate can be treated in a daylight-lit room. Examples of high-output lasers having a maximum intensity within a near infrared or infrared range include various lasers having a maximum intensity within a near infrared or infrared range of 760 to 1200 nm such as semiconductor lasers and YAG lasers.

The lithographic printing plate precursor of the present invention is converted into a lithographic printing plate having the image area formed thereon by writing images on the photosensitive layer using a laser, followed by a development treatment and removal of the non-image area using a wet method. In the present invention, a developing treatment may be conducted immediately after laser irradiation, and a heat-treating step can be provided between a laser irradiation step and a developing step. The heat treatment is preferably conducted under the conditions of a temperature within a range from 80 to 150°C for 10 seconds to 5 minutes. This heat treatment can reduce laser energy required for writing images during laser irradiation.

The developing solution used in the developing treatment includes, for example, an aqueous alkali solution (aqueous basic solution).

Examples of the alkali agent used in the developing solution include inorganic alkali compounds such as sodium silicate, potassium silicate, potassium hydroxide, sodium hydroxide, lithium hydroxide, sodium, potassium or ammonium salts of secondary or tertiary phosphoric acid, sodium metasilicate, sodium carbonate, and ammonia; and organic alkali compounds such as monomethylamine, dimethylamine, trimethylamide, monoethylamine, diethylamine, triethylamine, monoisopropylamine, diisopropylamine, triisopropylamine, n-butylamine, di-n-butylamine, monoethanolamine, diethanolamine, triethanolamine, ethyleneimine, and ethylenediamine.

The content of the alkali agent in the developing solution is preferably within a range from 0.005 to 10% by weight, and particularly preferably from 0.05 to 5% by weight. The content of the alkali agent in the developing solution of less than 0.005% by weight is not preferable because the development may not be conducted sufficiently. The content of more than 10% by weight is not preferable because an adverse influence such as corrosion of the image area is exerted on development.

An organic solvent can also be added to the developing solution. Examples of the organic solvent, which can be added to the developing solution, include ethyl acetate, butyl acetate, amyl acetate, benzyl acetate, ethylene glycol monobutyl acetate, butyl lactate, butyl levulinate, methyl ethyl ketone, ethyl butyl ketone, methyl isobutyl ketone, cyclohexanone, ethylene glycol monobutyl ether, ethylene glycol monobenzyl ether, ethylene glycol monophenyl ether, benzyl alcohol, methylphenyl carbitol, n-amyl alcohol, methylamyl alcohol, xylene, methylene dichloride, ethylene dichloride, and monochlorobenzene. When the organic solvent is added to the developing solution, the content of the organic solvent is preferably 20% by weight or less, and particularly preferably 10% by weight or less.

If necessary, it is also possible to add, in the developing solution, water soluble sulfites such as lithium sulfite, sodium sulfite, potassium sulfite, and magnesium sulfite; hydroxyaromatic compounds such as alkali-soluble pyrazolone compound, alkali-soluble thiol compound, and methyl resorcin; water softeners such as polyphosphate and aminopolycarboxylic acids; various surfactants, for example, anionic, nonionic, cationic, amphoteric and fluorine-based surfactants such as sodium isopropylnaphthalenesulfonate, sodium n-butylnaphthalenesulfonate, sodium N-methyl-N-pentadecylaminoacetate, and sodium lauryl sulfate; and various defoamers.

As the developing solution, commercially available developing solutions for a negative- or a positive-type PS plate can be used. Specifically, a solution prepared by diluting a commercially available concentrated developing solution for negative or positive type PS plate 1 to 1000 times can be used as the developing solution in the present invention.

The temperature of the developing solution is preferably within a range from 15 to 40°C, and the dipping time is preferably within a range from 1 second to 2 minutes. If necessary, the surface can be slightly rubbed during the development.

After the completion of the development treatment, the lithographic printing plate is washed with water and/or subjected to a treatment with an aqueous desensitizing agent (finishing gum). Examples of the aqueous desensitizing agent include aqueous solutions of water soluble natural polymers such as gum arabic, dextrin, and carboxymethyl cellulose, and aqueous solutions of water soluble synthetic polymers such as polyvinyl alcohol, polyvinyl pyrrolidone, and polyacrylic acid. If necessary, acids or surfactants are added to these aqueous desensitizing agents. After subjecting it to a treatment with the desensitizing agent, the lithographic printing plate is dried and then used for printing as a printing plate.

For the purpose of improving printing durability of the resulting lithographic printing plate, the lithographic printing plate can be subjected to a burning treatment or an post exposure treatment after the developing treatment.

The burning treatment is conducted by the steps of (i) washing the lithopgraphic printing plate obtained by the above-descried treating method with water and removing a rinsing solution or a gum solution, followed by squeegeeing, (ii) uniformly spreading a counter-etching solution over the plate, followed by drying, (iii) burning the plate in an oven under the temperature conditions within a range from 180 to 300°C for 1 to 30 minutes, and (iv) washing the cooled plate with water to remove the counter-etching solution, followed by gum coating and further drying.

The post exposure treatment is conducted by subjecting the surface of the image area side of the lithographic printing plate to entire surface exposure after the developing treatment. The post exposure treatment is preferably conducted by the entire surface post exposure at exposure energy that is 50 times smaller than that in case of the laser irradiation, preferably 1 to 30 times smaller than that in case of the laser irradiation, and more preferably 2 to 15 times smaller than that in case of the laser irradiation. When exposure energy upon post exposure is 50 times larger than that in case of the laser irradiation, sufficient printing durability may not be obtained. The exposure energy of laser irradiation is not specifically limited as far as it satisfies the above relation with exposure energy upon laser irradiation, and is preferably adjusted within a range from 10 mJ/cm2 to 10 J/cm², and more preferably from 50 mJ/cm2 to 8 J/cm², in view of the relation with the treating time.

The light source for post exposure is not specifically limited and examples thereof include a carbon arc, a high-pressure mercury lamp, an ultrahigh-pressure air-gun mercury lamp, a low-pressure mercury lamp, a deep UV lamp, a xenon lamp, a metal halide lamp, a fluorescent lamp, a tungsten lamp, a halogen lamp and an excimer laser lamp. Among these, a mercury lamp and a metal halide lamp is preferable and a mercury lamp are particularly preferable.

The post exposure treatment may be conducted in a state where the lithographic printing plate is at rest, or may be conducted while the lithographic printing plate is continuously transferred. In view of the strength of the image area, light intensity on the surface of the lithographic printing plate is preferably adjusted within a range from 20 mW/cm2 to 1 W/cm², and more preferably from 30 mW/cm2 to 500 mW/cm². To adjust the light intensity on the surface of the lithographic printing plate within the above range, the output of the light source to be used is increased. In case of a bar type light source, an output (W) of the light source is increased by increasing an output per unit length. Alternatively, exposure is conducted after bringing the surface of the lithographic printing plate close to the light source.

Upon post exposure, the temperature of the surface of the lithographic printing plate is preferably adjusted within a range from 40 to 300°C, and more preferably from 50 to 200°C, by heating using heating means such as radiation heat from a light source for post exposure, hot plate, dryer or ceramic heater. The heating means is preferably radiation heat from a light source because this is simple to do.

In the negative photosensitive lithographic printing plate as described above, a negative photosensitive composition, which is less likely to cause polymerization inhibition due to oxygen during radical polymerization and is excellent in storage stability, is used as a photosensitive layer. Thus, the resulting negative photosensitive lithographic printing plate shows high sensitivity and is excellent in printing durability and storage stability. The negative photosensitive composition of the present invention can be used for various purposes such as photoresist and a color filter, in addition to lithographic printing plate.

### EXAMPLES

The present invention will now be described in detail by way of examples, but the present invention is not limited to the scope of the following examples. The following syntheses relate to the general preparative method of onium salts.

### (Synthesis of onium salt (C-7)) .

In a 200 ml three-necked flask equipped with a stirrer, 6.35 g of Acid Green 25 (manufactured by Nippon Kayaku Co., Ltd. under the trade name of Kayanol Cyanine Green G) was charged and dissolved in 190 g of deionized water, and then 5.44 g of diphenyliodonium chloride (manufactured by Tokyo Kasei Kogyo Co., Ltd.) was charged, followed by stirring overnight at normal temperature. The resulting reaction solution was filtered, washed with water and then vacuum-dried to obtain 8.13 g of blackish blue crystals (the following formula (C-7)). Electron absorption analysis revealed that salt exchange was complete (absorption of iodonium: λmax = 228 nm, ε = 15321).

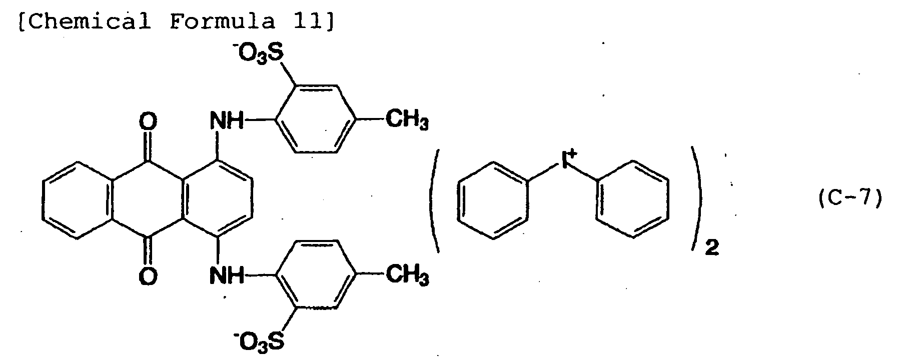

### (Synthesis of onium salt (C-8))

In a 200 ml three-necked flask equipped with a condenser and a stirrer, 30 g of 1-propanol and 18.8 g of deionized water were charged and, after the atmosphere in the flask was replaced with nitrogen, the liquid temperature was raised to 80°C. Then, a solution prepared by dissolving 30 g of 1-propanol, 18.8 g of deionized water, 3.75 g of sodium p-styrenesulfonate, 5.63 g of methyl methacrylate, 5.63 g of butyl methacrylate and 0.4 g of 2,2'-azobisisobutyronitrile was added dropwise over 2 hours. 2 hours after the completion of dropwise addition, 0.2 g of 2,2'-azobisisobutyronitrile was added again, followed by heating for 3 hours. A solution, prepared previously by dissolving 6.32 g of diphenyliodonium chloride (manufactured by Tokyo Kogyo Co., Ltd.) in 320 g of deionized water, was then added to the reaction solution. White turbidity was produced in the reaction solution. The solution was filtered, washed with water and then vacuum-dried to obtain 14.3 g of pale yellow crystals (the following formula (C-7), wherein q, r and s represent the number of a repeating unit). Electron absorption analysis revealed that salt exchange was complete (absorption of iodonium: λmax = 228 nm, ε = 15321).

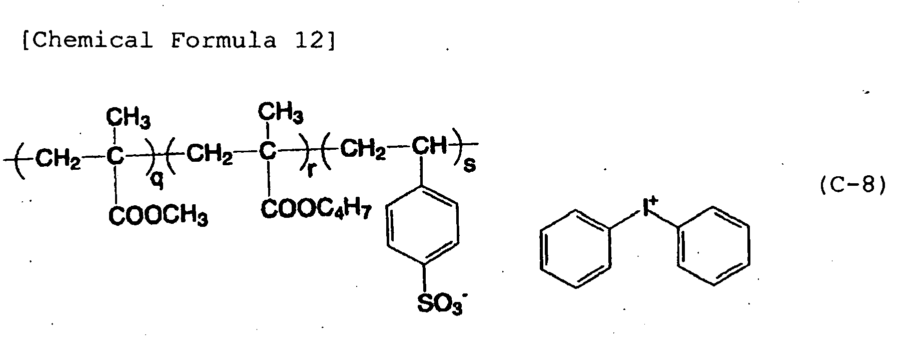

### (Synthesis of acrylic resin (E-1))

In a 300 ml three-necked flask equipped with a condenser and a stirrer, 100 g of N,N-dimethylacetamide was charged and, after the atmosphere in the flask was replaced with nitrogen, the liquid temperature was raised to 80°C. Then, a solution prepared by dissolving 7 g of allyl methacrylate, 6 g of acrylnitrile, 7 g of N-(4-carboxyphenyl)methacrylamide and 0.4 g of 2,2'-azobisisobutyronitrile in 80 g of N,N-dimethylacetamide was added dropwise over 2 hours. One hour after the completion of dropwise addition, 0.2 g of 2,2'-azobisisobutyronitrile was added again, followed by heating for 4 hours. The reaction solution was poured into 2 liters of water while stirring thereby to precipitate a white polymer. The resulting polymer was washed with water and then vacuum-dried to obtain an acrylic resin (E-1) having a repeating unit shown in the following formula (E-1) (wherein m, o and p represent the number of a repeating unit).

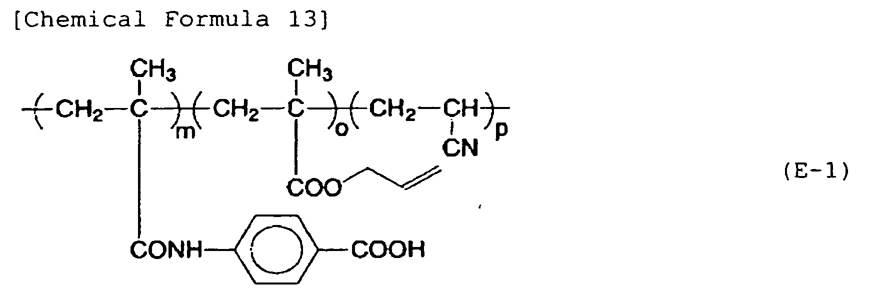

### (Synthesis of acrylic resin (E-2))

In a 300 ml three-necked flask equipped with a condenser and a stirrer, 100 g of N,N-dimethylacetamide was charged and, after the atmosphere in the flask was replaced with nitrogen, the liquid temperature was raised to 80°C. Then, a solution prepared by dissolving 13.0 g of allyl methacrylate, 7.0 g of an adduct (mixing ratio: 1:1) of methacryloyloxyethyl isocyanate and aminophenolsulfoamide and 0.4 g of 2,2'-azobisisobutyronitrile in 80 g of N,N-dimethylacetamide was added dropwise over 2 hours. One hour after the completion of dropwise addition, 0.2 g of 2,2'-azobisisobutyronitrile was added again, followed by heating for 4 hours. The reaction solution was poured into 2 liters of water while stirring thereby to precipitate a white polymer. The resulting polymer was washed with water and then vacuum-dried to obtain an acrylic resin (E-2) having a repeating unit shown in the following formula.

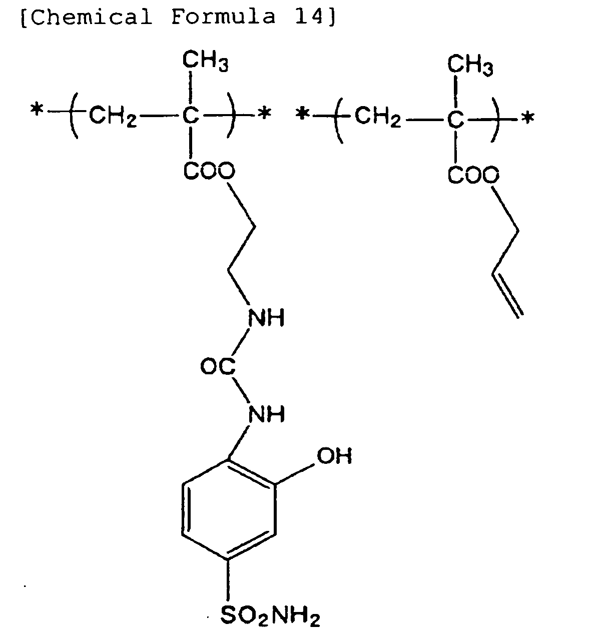

### [Example 1]

As is apparent from the formulation shown in Table 1, a coating solution of a negative photosensitive composition was prepared by dissolving 0.3 g (3% by weight) of a near infrared absorbing cationic dye (A-1) (manufactured by Showa Denko K.K. under the trade name of IRB) represented by the following formula (A-1) as the infrared absorber (A), 0.6 g (6% by weight) of an organic boron compound (B-1) (manufactured by Showa Denko K.K. under the trade name of P3B) represented by the following formula (B-1) as the organic boron compound (B), 0.9 g (9% by weight) of an onium salt (C-1) (manufactured by Wako Pure Chemicals Industries, Ltd.) represented by the above formula (6) as the onium salt (C), 3.0 g (30% by weight) of dipentaerythritol hexaacrylate (manufactured by Nippon Kayaku Co., Ltd.) as the compound having a polymerizable unsaturated group (D), 4.7 g (47% by weight) of the above acrylic resin (E-1) which is an alkali-soluble resin as the binder resin (E) and 0.2 g of DC-190 (10%, ethylene glycol monomethyl ether solutions,*) as the surfactant and 0.3 g of D-11 (manufactured by PCAS Co.) as the colorant in a solvent of 70.0 g of ethylene glycol monomethyl ether and 20.0 g of methyl ethyl ketone.
*manufactured by Eastman Kodak Company

A 0.30 mm thick aluminum plate was degreased with an aqueous sodium hydroxide solution and then subjected to an electrolytic polishing treatment in a 2% hydrochloric acid bath to obtain a grained plate having a center line average roughness (Ra) of 0.55 µm. This grained plate was anodized in a 20% sulfuric acid bath at a current density of 2 A/dm² to form an oxide film (2.6 g/m²), passed through an aqueous 2.5% sodium silicate solution at 70°C for 30 seconds, washed with water and then dried to obtain an aluminum support. A coating solution of the above negative photosensitive composition was applied on the aluminum support using a roll coater and then dried at 110°C for 30 seconds to obtain a negative photosensitive lithographic printing plate. The dry coating weight was 2.0 g/m².

The photosensitive lithographic printing plate immediately after the production was imagewise exposed by an exposure apparatus equipped with a near infrared semiconductor laser (Trendsetter 3244, manufactured by CREO Co., wavelength: 830 nm, laser output: 10 W, rotation number: 150 rpm). After exposure, the photosensitive lithographic printing plate was developed with a developing solution (solution mixture of 700 parts by volume of water, 40 parts by volume of a surfactant PELEX NBL manufactured by Kao Corporation and 14 parts by volume of potassium silicate) at 30°C for 15 seconds using an automatic processor (manufactured by FUJI PHOTO FILM CO., LTD. under the trade name of PS-900N). Sensitivity and printing durability of the resulting lithographic printing plate were evaluated. The results are shown in Table 2.

### (Sensitivity)

With respect to the dots on the lithographic printing plate after subjecting it to the developing treatment, reproducibility was confirmed and evaluated. In Table 2, the symbol A indicates good reproducibility of dots, and reproducibility of dots deteriorates in order of the symbols B, C, D and E.

### (Storage stability)

With respect to storage stability, the photosensitive lithographic printing plate was stored under the conditions of 38°C and 80%RH for one week and then any change in the developing properties was confirmed and evaluated. In Table 2, the symbol A indicates excellent storage stability, and storage stability deteriorates in order of the symbols B, C, D and E.

### (Printing durability)

The lithographic printing plate used in the evaluation of sensitivity was mounted on a Sprint-26 (manufactured by Komori Co., Ltd.) and printing was conducted using red No.2 (manufactured by Kodak Polychrome Graphics) as an ink and using a solution mixture of 98 parts by weight of water, 1 part by weight of isopropyl alcohol and 1 part by weight of NA108W (manufactured by DAINIPPON INK & CHEMICALS Co., Ltd.) as dampening water. After printing 30,000 sheets, the image area was observed and evaluated by the degree of abrasion. In Table 2, the symbol A indicates excellent printing durability, and printing durability deteriorates in order of the symbols B, C, D and E.

### [Examples 2 to 10, Comparative Examples 1 to 3]

In the same manner as in Example 1, except that the formulation of the coating solution was replaced by the formulation shown in Table 1, negative photosensitive lithographic printing plates were produced and evaluated. The evaluation results are shown in Table 2. A near infrared absorbing cationic dye (A-2) in Table 1 is represented by the following formula (A-2) (manufactured by Eastman Chemical Company), a near infrared absorbing cationic dye(A-3) is represented by the following formula (A-3) (manufactured by Showa Denko K.K. under the trade name of IRT), an organic boron compound (B-2) is represented by the following formula (B-2) (manufactured by Showa Denko K.K. under the trade name of NP3B), an onium salt (C-2) is represented by the above formula (7), an onium salt (C-5) is represented by the following formula (C-5) (manufactured by Wako Pure Chemicals Industries, Ltd.), an onium salt (C-6) is represented by the following formula (C-6) (manufactured by Wako Pure Chemicals Industries, Ltd.) and a polymerization initiator is represented by the following formula (8) (manufactured by PCAS Co. under the trade name of Triazine B).

**[Table 1]**

| Coating solution of negative photosensitive composition (unit: g) | Examples | | | | | | Comparative Examples | | |
|---|---|---|---|---|---|---|---|---|---|
| | 1 | 2 | 3 | 4 | 5 | 6 | 1 | 2 | 3 |
| Near infrared absorbable cationic dye A-1 | 0.3 | 0.3 | | 0.3 | 0.3 | 0.3 | 0.3 | 0.3 | |
| Near infrared absorbable cationic dye A-2 | | | | | | | | | 0.3 |
| Near infrared absorbable cationic dye A-3 | | | 0.3 | | | | | | |
| organic boron compound B-1 | 0.6 | | 0.6 | 0.6 | 0.6 | 0.6 | 0.6 | | 0.6 |
| Organic boron compound B-2 | | 0.6 | | | | | | | |
| Onium salt (C-1) | 0.9 | 0.9 | 0.9 | | | | | 0.9 | 0.9 |
| Onium salt (C-2) | | | | 0.9 | | | | | |
| Onium salt (C-5) | | | | | 0.9 | | | | |
| Onium salt (C-6) | | | | | | 0.9 | | | |
| Pentaerythritol hexaacrylate | 3.0 | 3.0 | 3.0 | 3.0 | 3.0 | 3.0 | 3.0 | 3.0 | 3.0 |
| Acrylic resin E-1 | 4.7 | 4.7 | 4.7 | 4.7 | 4.7 | 4.7 | 4.7 | 4.7 | 4.7 |
| Polymerization initiator (8) | | | | | | | | 0.6 | |
| DC190 (10% solution) | 0.2 | 0.2 | 0.2 | 0.2 | 0.2 | 0.2 | 0.2 | 0.2 | 0.2 |
| D-11 | 0.3 | 0.3 | 0.3 | 0.3 | 0.3 | 0.3 | 0.3 | 0.3 | 0.3 |
| Ethylene glycol monomethyl ethe | 70.0 | 70.0 | 70.0 | 70:0 | 70.0 | 70.0 | 70.0 | 70.0 | 70.0 |
| Methyl ethyl ketone | 20.0 | 20.0 | 20.0 | 20.0 | 20.0 | 20.0 | 20.0 | 20.0 | 20.0 |

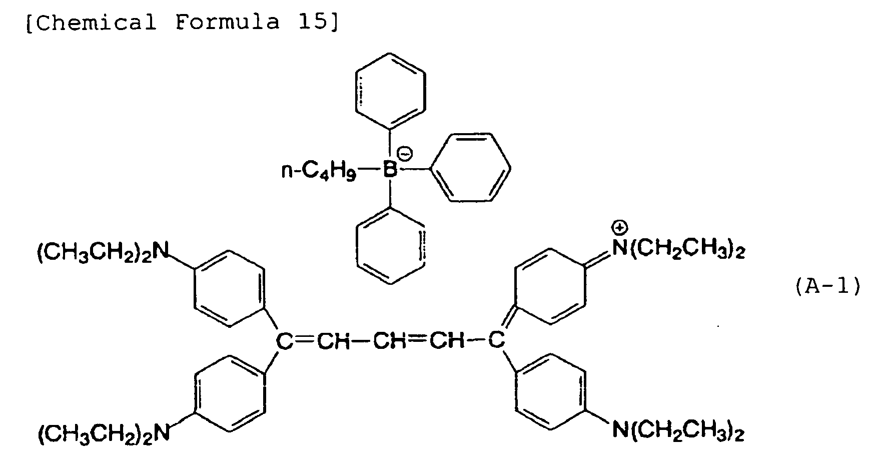

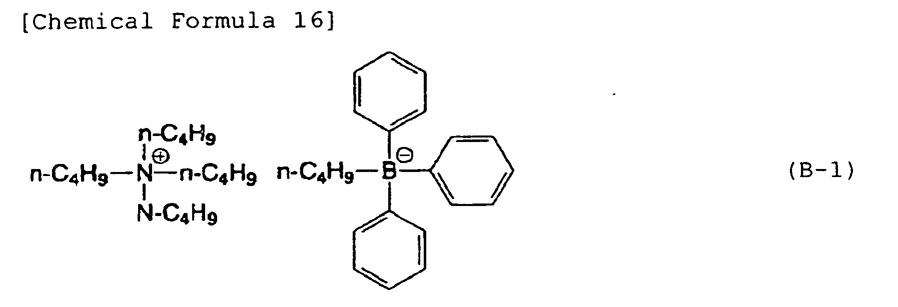

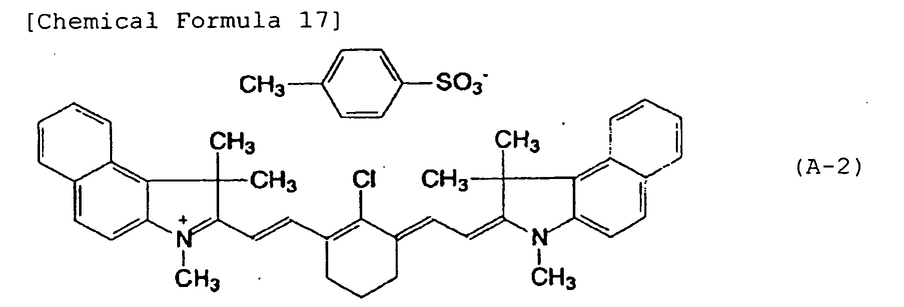

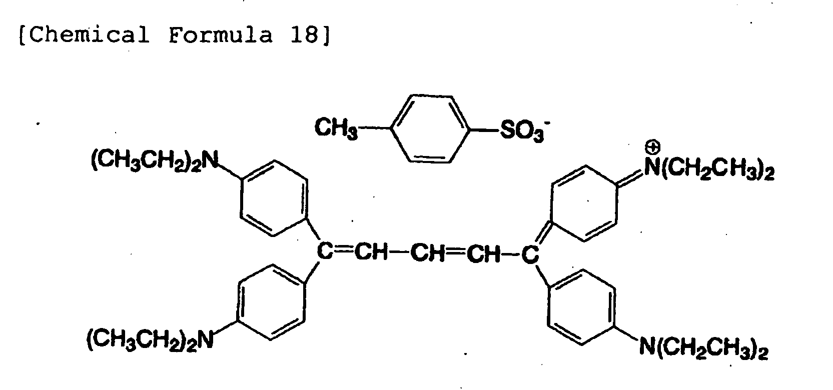

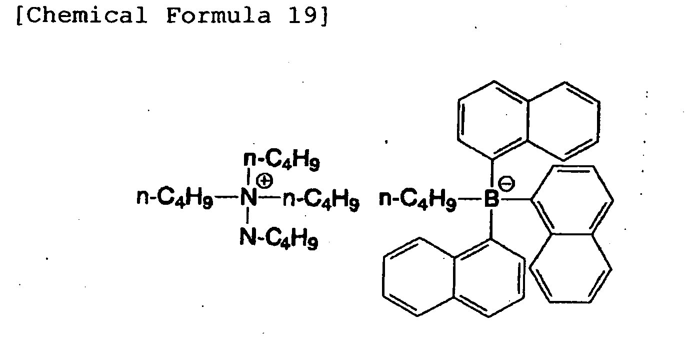

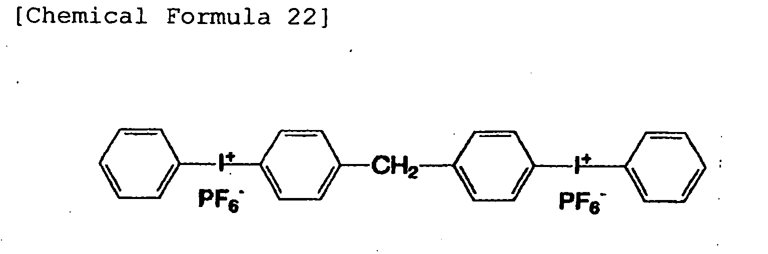

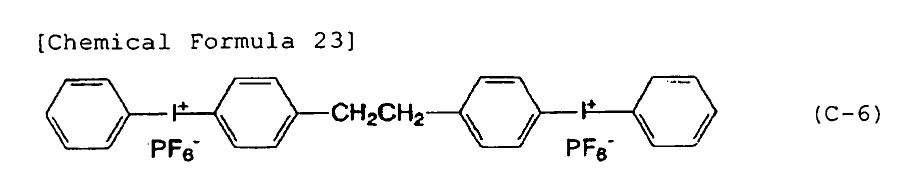

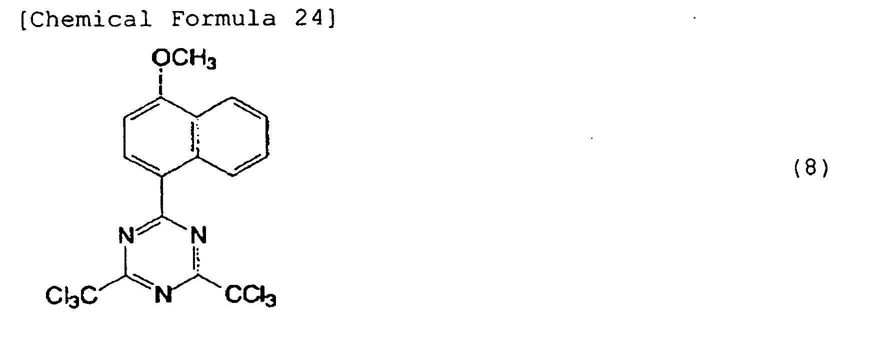

**[Table 2]**

| Evaluation | Examples | | | | | | Comparative Example | | |
|---|---|---|---|---|---|---|---|---|---|
| | 1 | 2 | 3 | 4 | 5 | 6 | 1 | 2 | 3 |
| Sensitivity | A | A | B | A | A | A | E | E | E |
| | | | | | | | impossible to form images | impossible to form images | impossible to form images |
| Storage stability | A | A | A | A | A | A | Impossible to evaluate | Impossible to evaluate | Impossible to evaluate |
| Printing durability | A | A | B | A | A | A | Impossible to evaluate | Impossible to evaluate | Impossible to evaluate |

As is apparent from the results shown in Table 2, the negative photosensitive lithographic printing plates of Examples 1 to 6 showed high sensitivity and were excellent in printing durability and storage stability. In case of the negative photosensitive lithographic printing plate containing no onium salt (C) of Comparative Example 1, the negative photosensitive lithographic printing plate of Comparative Example 2 in which the other polymerization initiator (triazines) was used in place of the organic boron compound (B), and the negative photosensitive lithographic printing plate of Comparative Example 3 in which the infrared absorber (A) and the organic boron compound (B), which can not initiate radical polymerization, are used in combination, images could not be formed and also printing durability and storage stability could not be evaluated.

### [Examples 7 to 11, Comparative Examples 4 to 5]

In the same manner as in Example 1, except that the formulation of the coating solution was replaced by the formulation shown in Table 3, negative photosensitive lithographic printing plates were produced and evaluated. The evaluation results are shown in Table 4. The near infrared absorbing cationic dye (A-2) in Table 3 is the same as that used in Comparative Example 3, the onium salts (C-1) and (C-2) are the same as those used in Examples 1 to 4, the acrylic resin (E-3) is an allyl methacrylate-methacrylic acid copolymer (manufactured by Gifu Shellac Mfg., Co., Ltd.), and the polymerization initiator is the same as that used in Comparative Example 2.

**[Table 3]**

| Coating solution of negative sensitive | Examples | | | | | Comparative Examples | |
|---|---|---|---|---|---|---|---|
| (unit: g) | 7 | 8 | 9 | 10 | 11 | 4 | 5 |
| Near infrared absorbing cationic dye (A-1) | 0.2 | 0.2 | 0.2 | 0.2 | 0.2 | | 0.2 |
| Infrared absorber (A-2) | | | | | | 0.2 | |
| Organic boron compound (B-1) | 0.6 | | 0.6 | 0.6 | 0.6 | 0.6 | |
| Organic boron compound (B-2) | | 0.6 | | | | | |
| Onium salt (C-1) | 0.9 | 0.9 | 0.9 | | 0.9 | 0.9 | 0.9 |
| Onium salt (C-2) | | | | 0.9 | | | |
| Pentaerythritol hexaacrylate | 3.0 | 3.0 | 3.0 | 3.0 | 3.0 | 3.0 | 3.0 |
| Acrylic resin (E-1) | 4.8 | 4.8 | | 4.8 | | 4.8 | 4.8 |
| Acrylic resin (E-2) | | | 4.8 | | | | |
| Acrylic resin (E-3) | | | | | 4.8 | | |
| Polymerization initiator | | | | | | | 0.6 |
| DC190 (10%) | 0.2 | 0.2 | 0.2 | 0.2 | 0.2 | 0.2 | 0.2 |
| Crystal violet | 0.3 | 0.3 | 0.3 | 0.3 | 0.3 | 0.3 | 0.3 |
| Ethylene glycol monomethyl ether | 70.0 | 70.0 | 70.0 | 70.0 | 70.0 | 70.0 | 70.0 |
| Methyl ethyl ketone | 20.0 | 20.0 | 20.0 | 20.0 | 20.0 | 20.0 | 70.0 |

**[Table 4]**

| | Examples | | | | | Comparative Examples | |
|---|---|---|---|---|---|---|---|
| | 7 | 8 | 9 | 10 | 11 | 4 | 5 |
| Sensitivity | B | B | A | B | B | E | E |
| Developing properties | A | A | A | B | A | E | E |
| Printing durability | A | A | B | B | A | E | E |
| Change with time | A | A | A | A | E | E | E |

### <Evaluation criteria>

A: considerably good
B: good
C: level suitable for practical use
D:. slightly poor
E: poor, or impossible to evaluate

As is apparent from the results shown in Table 4, the negative photosensitive lithographic printing plates of Examples 7. to 11 showed high sensitivity and were excellent in developing properties and printing durability. The negative photosensitive lithographic printing plate wherein an alkali-soluble binder resin (E) or a binder resin (E) having an aromatic carboxyl group was excellent in storage stability. Regarding the negative photosensitive lithographic printing plate of Comparative Example 4 wherein a combination of an infrared absorber (A) and an organic boron compound (B), which can not initiate radical polymerization, is used and the negative photosensitive lithographic printing plate of Comparative Example 5 wherein other polymerization initiators (triazines) were used in place of the organic boron compound (B), images could not be formed and it was impossible to evaluate printing durability and storage stability.

### INDUSTRIAL APPLICABILITY

The negative photosensitive lithographic printing plate of the present invention can directly perform plate-making by irradiation with an infrared laser beam based on digital signals without being preheated and, therefore, a plate-making operation can be simplified. Furthermore, a plate-making time can be decreased because of the high sensitivity and, also, the printing cost can be reduced because of the excellent printing durability.

## Claims

1. A negative photosensitive composition comprising:
(A) an infrared absorber,
(B) an organic boron compound which has a function as a polymerization initiator when used in combination with the infrared absorber (A),
(C) an onium salt having at least two onium ion atoms in a molecule, and
(D) a compound having a polymerizable unsaturated group.

2. The negative photosensitive composition according to claim 1, wherein the infrared absorber (A) is a near infrared absorbing cationic dye represented by the following formula (1):
D⁺A⁻ (1)
wherein
D⁺ represents a cationic dye having an absorption in a near infrared range, and
A⁻ represents an anion.

3. The negative photosensitive composition according to claim 1, wherein the organic boron compound (B) is an ammonium salt of a quaternary boron anion represented by the following formula (2): 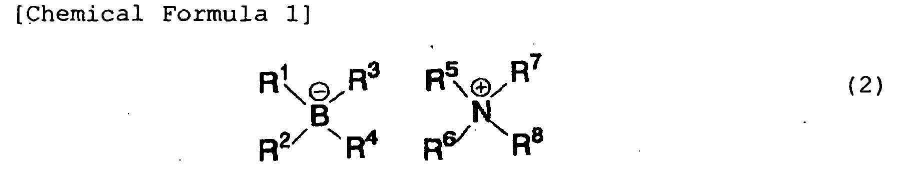 wherein
R¹, R², R³ and R⁴ each independently represents an alkyl group, an aryl group, an alkaryl group, an allyl group, an aralkyl group, an alkenyl group, an alkynyl group, an alicyclic group, or a saturated or unsaturated heterocyclic group,
at least one of R¹, R², R³ and R⁴ is an alkyl group having 1 to 8 carbon atoms, and
R⁵, R⁶, R⁷ and R⁸ each independently represents a hydrogen atom, an alkyl group, an aryl group, an allyl group, an alkaryl group, an aralkyl group, an alkenyl group, an alkynyl group, an alicyclic group, or a saturated or unsaturated heterocyclic group.

4. The negative photosensitive composition according to claim 1, wherein the onium ion-atoms of the onium salt (C) are S⁺ and I⁺.

5. The negative photosensitive composition according to claim 1, wherein the onium salt (C) has an aromatic ring having a substituent.

6. The negative photosensitive composition according to claim 1, which further contains a binder resin (E).

7. The negative photosensitive composition according to claim 6, wherein the binder resin (E) is an alkali-soluble resin.

8. The negative photosensitive composition according to claim 6, wherein the binder resin (E) comprises a polymer having an aromatic carboxyl group.

9. A negative photosensitive lithographic printing plate comprising a support and a photosensitive layer containing the negative photosensitive composition according to any one of claims 1 to 8 formed on the support.

## Patentansprüche

1. Negative lichtempfindliche Zusammensetzung aus:
A) einem Infrarotabsorbens;
B) einer organischen Boronverbindung, die eine Funktion als Polymerisationsinhibitor bei Verwendung in Kombination mit dem Infrarotabsorbens (A) aufweist,
C) einem Oniumsalz mit mindestens zwei Oniumionatomen in einem Molekül, und
D) einer Verbindung mit einer polymerisierbaren, ungesättigten Gruppe.

2. Negative, lichtempfindliche Zusammensetzung nach Anspruch 1, worin das Infrarotabsorbens (A) ein nahinfrarotabsorbierender, kationischer Farbstoff ist, dargestellt durch folgende Formel (1):
D⁺A⁻ (1)
worin
D⁺ für einen kationischen Farbstoff mit einer Absorption in einem nahinfraroten Bereich steht, und
A⁻ für ein Anion steht.

3. Negative, lichtempfindliche Zusammensetzung nach Anspruch 1, worin die organische Boronverbindung (B) ein Ammoniumsalz eines quaternären Boronanions ist, dargestellt durch folgende Formel (2): 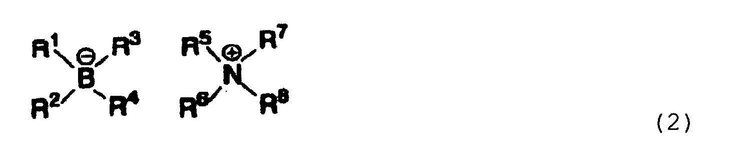 worin
R¹, R², R³ und R⁴ jeweils unabhängig für eine Alkylgruppe, eine Arylgruppe, eine Alkarylgruppe, eine Allylgruppe, eine Aralkylgruppe, eine Alkenylgruppe, eine Alkynylgruppe, eine alizyklische Gruppe oder eine gesättigte oder ungesättigte, heterozyklische Gruppe stehen,
mindestens R¹, R², R³ oder R⁴ für eine Alkylgruppe mit 1 bis 8 Kohlenstoffatomen stehen, und
R⁵, R⁶, R⁷ und R⁸ jeweils unabhängig für ein Wasserstoffatom, eine Alkylgruppe, eine Arylgruppe, eine Allylgruppe, eine Alkarylgruppe, eine Aralkylgruppe, eine Alkenylgruppe, eine Alkynylgruppe, eine alizyklische Gruppe oder eine gesättigte oder ungesättigte, heterozyklische Gruppe stehen.

4. Negative, lichtempfindliche Zusammensetzung nach Anspruch 1, worin die Oniumionatome des Oniumsalzes (C) S⁺ und I⁺ sind.

5. Negative, lichtempfindliche Zusammensetzung nach Anspruch 1, worin das Oniumsalz (C) einen aromatischen Ring mit einem Substituenten aufweist.

6. Negative, lichtempfindliche Zusammensetzung nach Anspruch 1, welche zudem ein Bindemittelharz (E) enthält.

7. Negative, lichtempfindliche Zusammensetzung nach Anspruch 6, worin das Bindemittelharz (E) ein alkalisch lösliches Harz ist.

8. Negative, lichtempfindliche Zusammensetzung nach Anspruch 6, worin das Bindemittelharz (E) ein Polymer mit einer aromatischen Carboxylgruppe umfasst.

9. Negative, lichtempfindliche Offsetdruckplatte mit einem Träger und einer auf dem Träger ausgebildeten lichtempfindlichen Schicht, die die negative, lichtempfindliche Zusammensetzung nach einem der Ansprüche 1 bis 8 enthält.

## Revendications

1. Composition photosensible négative comprenant :
A) un absorbant infrarouge,
B) un composé de bore organique qui a une fonction d'initiateur de polymérisation lorsqu'il est utilisé en combinaison avec l'absorbant infrarouge (A),
C) un sel d'onium ayant au moins deux ions onium dans une molécule, et
D) un composé comportant un groupe non saturé polymérisable.

2. Composition photosensible négative selon la revendication 1, dans laquelle l'absorbant infrarouge (A) est un colorant cationique absorbant le proche infrarouge représenté par la formule suivante (1) :
D⁺A⁻ (1)
où
D⁺ représente un colorant cationique présentant une absorption dans une plage du proche infrarouge, et
A⁻ représente un anion.

3. Composition photosensible négative selon la revendication 1, dans laquelle le composé de bore organique (B) est un sel d'ammonium d'un anion bore quaternaire représenté par la formule suivante (2) : 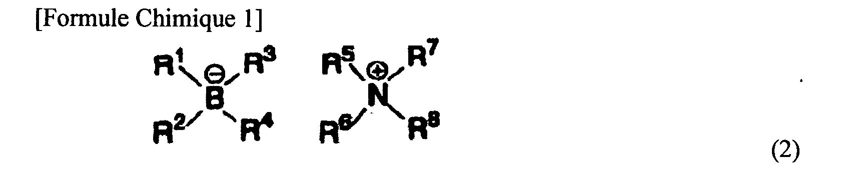 où
R¹, R², R³ et R⁴ représentent chacun indépendamment un groupe alkyle, un groupe aryle, un groupe alkaryle, un groupe allyle, un groupe aralkyle, un groupe alcényle, un groupe alkynyle, un groupe alicyclique, ou un groupe hétérocyclique saturé ou non saturé,
au moins l'un des groupes R¹, R², R³ et R⁴ est un groupe alkyle ayant de 1 à 8 atomes de carbone, et
R⁵, R⁶, R⁷ et R⁸ représentent chacun indépendamment un atome d'hydrogène, un groupe alkyle, un groupe aryle, un groupe allyle, un groupe alkaryle, un groupe aralkyle, un groupe alcényle, un groupe alkynyle, un groupe alicyclique ou un groupe hétérocyclique saturé ou non saturé.

4. Composition photosensible négative selon la revendication 1, dans laquelle les ions onium du sel d'onium (C) sont S⁺ et I⁺.

5. Composition photosensible négative selon la revendication 1, dans laquelle le sel d'onium (C) a un cycle aromatique comportant un substituant.

6. Composition photosensible négative selon la revendication 1, qui contient en outre une résine de liant (E).

7. Composition photosensible négative selon la revendication 6, dans laquelle la résine de liant (E) est une résine soluble dans une base.

8. Composition photosensible négative selon la revendication 6, dans laquelle la résine de liant (E) comprend un polymère comportant un groupe carboxyle aromatique.

9. Plaque d'impression lithographique photosensible négative comportant un support et une couche photosensible contenant la composition photosensible négative selon l'une quelconque des revendications 1 à 8 formée sur le support.
